Europäisches Patentamt

(19) European Patent Office

Office européen des brevets

(11) Publication number: **0 283 923**
**B1**

# EUROPEAN PATENT SPECIFICATION

(45) Date of publication of the patent specification:
25.07.90

(51) Int. Cl.⁵: **C23C 16/30, C23C 14/34,**
**C03C 17/36, B32B 15/00**

(21) Application number: 88104212.1

(22) Date of filing: 17.03.88

(54) Sputtered titanium oxynitride films.

(30) Priority: 26.03.87 US 31315
26.03.87 US 31317
26.03.87 US 31319

(43) Date of publication of application:
28.09.88 Bulletin 88/39

(45) Publication of the grant of the patent:
25.07.90 Bulletin 90/30

(84) Designated Contracting States:
AT BE CH DE ES FR GB GR IT LI LU NL SE

(56) References cited:
EP-A- 0 083 043
DE-B- 2 851 584

Metals Handbook, vol. 5, Chapter "Sputtering",
pages 412-415
Patent Abstracts of Japan, unexamined applications, C
filed, vol. 9, 41, February 1985 - The Patent Office
Japanese Government , page 140 c 267
Patent Abstracts of Japan unexamined applications, C
filed, vol. 6, no. 63, April 22, 1982 - the Patent Office
Japanese Government, page 42 C 99
Patent Abstracts of Japan, unexamined applications, C
filed. vol. 5, no. 49, April 8, 1981 - The Patent Office
Japanese Government,page 95 C 49

(73) Proprietor: PPG INDUSTRIES, INC., One PPG Place,
Pittsburgh Pennsylvania 15272(US)

(72) Inventor: Gillery, Frank Howard, 2790 Indian Spring Lane,
Allison Park Pennsylvania 15101(US)

(74) Representative: Sternagel, Hans-Günther, Dr. et al,
Patentanwälte Dr. Michael Hann Dr. H.-G. Sternagel
Sander Aue 30, D-5060 Bergisch Gladbach 2(DE)

(56) References cited: (continuation)
Patent Abstracts of Japan, unexamined applications, C
filed, vol. 5, no. 28, February 20, 1981 - The Patent Office
Japanese Government, page 122 C 44

ACTORUM AG

## Description

The present invention relates generally to the art of sputtering metal-containing films on non-metallic substrates, and more particularly to the art of magnetic sputtering of multiple-layer metal-dielectric transparent films on glass.

US-A 3 990 784 to Gelber discloses a coated architectural glass system comprising a transparent substrate and a multilayer coating comprising first and second metal layers with a dielectric layer between them, wherein the first and second metal layers have a thickness ratio so that the transmission of the coating can be changed independent of its reflection properties by varying the thickness of the metal layers while maintaining the ratio constant. The dielectric has a thickness such that the reflection from the coating is not strongly colored.

US-A 4 022 947 to Grubb et al discloses a transparent panel capable of transmitting a desired portion of visible radiation while reflecting a large portion of incident solar radiation and a method of preparing same, by sputtering an iron, nickel and chromium alloy to obtain a transparent metal film, and reactively sputtering the same or a similar alloy in the presence of oxygen to form an oxide film. In one preferred embodiment, the metal film lies between the substrate and the metal oxide film. In another preferred embodiment, the metal oxide film lies between the substrate and the metal film.

US-A 4 534 841 to Hartig, et al. discloses solar-control glazing produced by applying first an oxide layer having an optical thickness of 20 to 280 nanometers to a transparent substrate by cathodic evaporation and second a chromium nitride layer having a geometric thickness of 10 to 40 nanometers. An optical third dielectric layer may be applied to the second layer. The oxide layer is selected from oxides of tin, titanium, and aluminum.

US-A 4 535 000 to Gordon discloses placing a thin film of metal nitride, e.g. titanium nitride, on a glass substrate by mixing a metal halide with a reducing gas like ammonia at 250 to 320°C and reacting the gases at the glass surface heated to 400° to 700°C to form the film on the glass.

US-A 4 546 050 to Amberger et al discloses a glass sheet with a multilayer coating selected from the group consisting of copper, stainless steel, titanium dioxide; copper, titanium, titanium dioxide; and copper, titanium, titanium nitride.

Architectural glass products with metallic and/or metal oxide films are growing in importance as energy demands for heating and cooling become increasingly expensive. Coated glass architectural products generally fall into two categories, solar energy control and high transmittance/low emissivity coated products.

Solar energy control products are generally glass substrates, often tinted, coated with a low visible transmittance colored film which reduces solar energy transmittance through the windows into the building interior, thereby reducing air conditioning costs. These products are most effective in warm climates and are most often seen in commercial construction. In areas where heating costs are of greater concern, and particularly in residential construction, high transmittance/low emissivity coatings are desirable in order to allow high transmittance of visible light into the interior while reflecting infrared radiation to retain heat inside the building. High transmittance/low emissivity coatings are typically multiple layer films wherein an infrared reflecting metal such as silver, gold or copper is sandwiched between anti-reflective metal oxide layers such as bismuth, indium and/or tin oxides. Solar energy control films, on the other hand, are typically single layer films of one or more of the metals or oxides of metals such as cobalt, iron, chromium, nickel, copper, etc.

Wet chemical methods for producing metallic films for solar energy control are well known from US-A 3 846 152; 4 091 172; 3 723 158 and 3 457 138. Pyrolytic methods for producing metal oxide films for solar energy control are well known from US-A 3 660 061; 3 658 568; 3 978 272 and 4 100 330.

Sputtering technologies for producing high transmittance/low emissivity multiple layer coatings are disclosed in US 4 462 884 and No. 4 508 789. Sputtering techniques for producing solar control films are disclosed in US-A 4 512 863 and US-A 4 594 137.

JP-A- 572 875 (Patent Abstracts of Japan, Vol.6, No. 63, April 22nd, 1982 page 42C99) describes vacuum deposition of $\geq 1$ kinds of elements selected from B, C, N, and O and of Ti to form colored TiN, TiO Ti($N_xO_y$) Ti($C_xN_y$) and Ti($C_xN_yO_z$) protective coatings on wristwatch cases.

In Metals Handbook 1982, Vol.5, Chapter «Sputtering» on pages 412 to 415 the coating of substrates by sputtering is described. Reactive sputtering using a gas to introduce one or more of the coating constituents is mentioned.

Sputtering of a Ti-target in an Ar + $N_2$ atmosphere results in hard TiN wear coatings for tools. The ability to control coating compositions makes sputtering useful in the electronics industry for applications such as a morphous optical films for integrated optical devices, transparent conducting electrodes, etc.

It is the object of the invention to provide a method of coating transparent nonmetallic substrates with a dielectric film for the use of the coated article as structural elements.

This object is attained by a method of making a coated article by placing a substrate in a coating chamber, evacuating said chamber and providing a nitrogen comprising reactive atmosphere and depositing a coating onto the surface of said substrate by sputtering a titanium cathode facing the surface of said substrate, characterized by providing an atmosphere further comprising oxygen on said chamber and depositing a transparent titanium oxynitride coating on said surface of a transparent non-metallic substrate.

This object is also attained by the use of the coated article prepared according to the claims 1 to 6, 9 and 15 as a structural element for reflectance of solar energy; the use of the coated article prepared according to the claims 1 to 9 and 15 having a reduced total luminous reflectance as a structural element for the reflectance of solar energy; the use of the coated article prepared according to the claims 1 to 3 and 10 to 15 as a colored architectural product.

The present invention provides a novel and superior dielectric film for use in a wide variety of multiple-layer architectural coatings on glass. The present invention involves sputtering a titanium cathode in an atmosphere comprising oxygen and nitrogen in order to deposit a coating comprising titanium oxynitride. The titanium oxynitride film of the present invention may be deposited in combination with an infrared reflective film such as silver to form a multilayer low emissivity film. The titanium oxynitride film of the present invention may also be deposited in combination with a metal alloy film such as stainless steel or Inconel to form a variety of colored multilayer coatings with relatively saturated colors. The titanium oxynitride film of the present invention may also be deposited in combination with both an infrared reflective film such as silver and a metal film which reduces the luminous reflectance, particularly a metal alloy film such as Inconel, to produce a multilayer coating which has a relatively saturated color and low emissivity.

## Brief Description of the Drawing

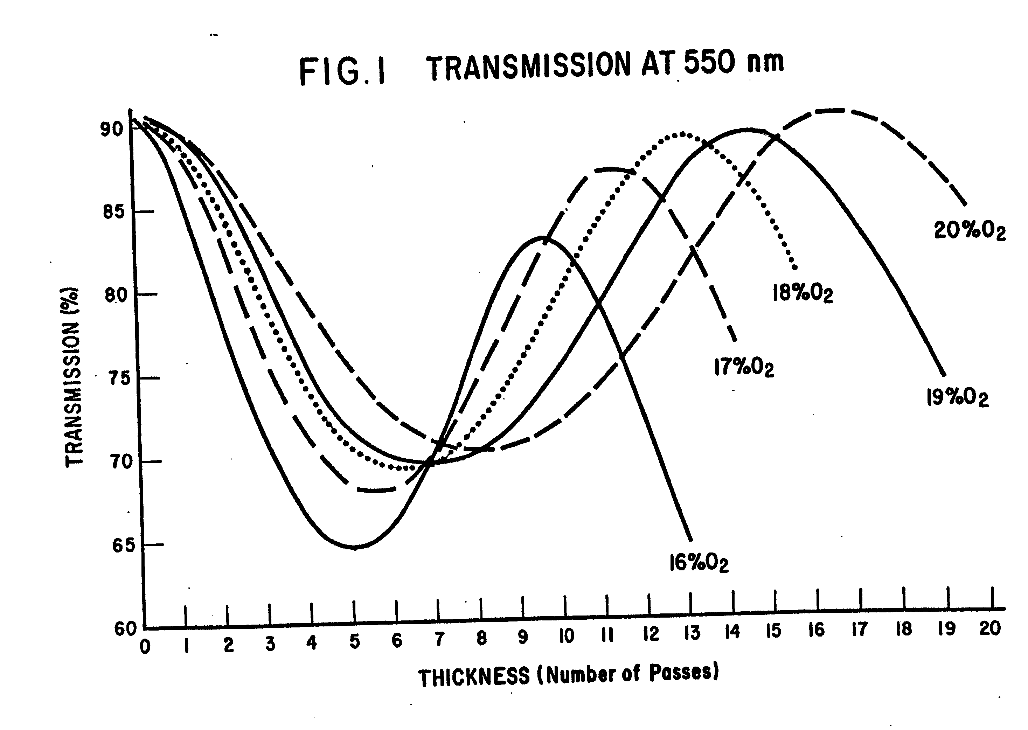

Figure 1 illustrates the transmittance at 550 nanometers (nm) of a titanium oxynitride film on glass as a function of film thickness, measured in number of cathode passes, at various percentages of oxygen in nitrogen.

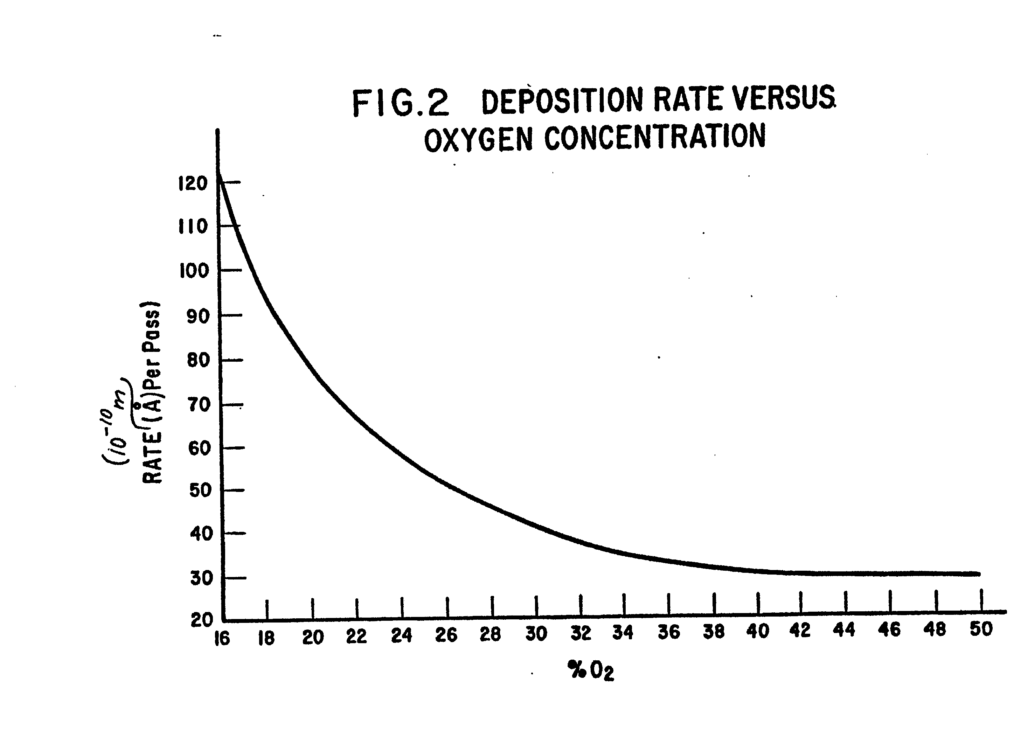

Figure 2 illustrates the deposition rate of titanium oxynitride, in $10^{-10}m$ (Angstroms) per cathode pass, as a function of the percentage of oxygen in the atmosphere of the coating chamber.

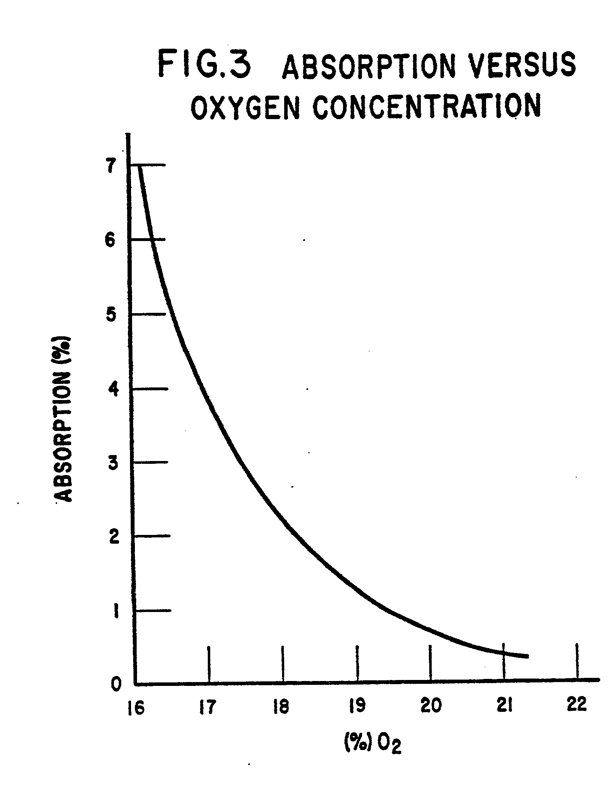

Figure 3 illustrates the absorption of a titanium oxynitride film about $6 \times 10^{-8}m$ (600 Angstroms) thick as a function of the percentage of oxygen in the atmosphere of the coating chamber.

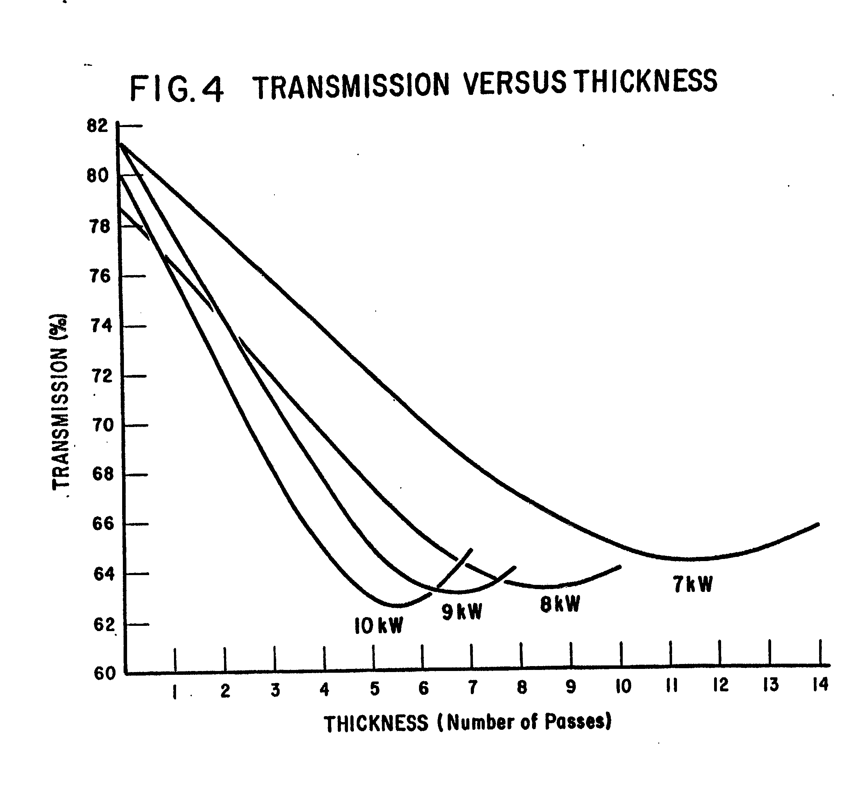

Figure 4 illustrates the transmittance at 550 nanometers of a titanium oxynitride film over an Inconel film as a function of film thickness at various cathode power levels.

## Detailed Description of the Preferred Embodiments

A transparent, nonmetallic substrate, preferably glass, is coated by cathode sputtering, preferably magnetron sputtering, to provide a product comprising titanium oxynitride with desirable durability and aesthetic properties.

In a conventional magnetron sputtering process, a substrate is placed within a coating chamber in facing relation with a cathode having a target surface of the material to be sputtered. Preferred substrates in accordance with the present invention include glass, ceramics and plastics which are not detrimentally affected by the operating conditions of the coating process.

The cathode may be of any conventional design, preferably an elongated rectangular design, connected with a source of electrical potential, and preferably employed in combination with a magnetic field to enhance the sputtering process. At least one cathode target surface comprises titanium which is sputtered in a reactive atmosphere to form a titanium oxynitride film. The anode is preferably a symmetrically designed and positioned assembly as taught in US-A 4 478 702 by Gillery et al.

The titanium oxynitride of the present invention is deposited by sputtering a titanium cathode in an atmosphere comprising oxygen and nitrogen. The composition of the atmosphere preferably ranges from 10 to 50 percent oxygen and from 90 to 50 percent nitrogen. An atmosphere comprising 10 to 25 percent oxygen and the balance nitrogen is particularly preferred.

The figures show that the properties of the titanium oxynitride change gradually and continuously as the gas composition changes. In contrast, titanium sputtered in an oxygen/argon atmosphere exhibits an abrupt change from oxide to metal. The figures further show that it is possible to choose deposition conditions such that a titanium oxynitride film with desired transmittance and absorbance properties can be sputtered at a desired rate.

Certain desired coating colors can be produced for architectural purposes by combining a colorless dielectric material with inner and outer colored metal layers, or by combining colored metal oxide with a reflective metal. In accordance with the present invention, desired coating colors are obtained by combining titanium oxynitride with a highly infrared reflective metal such as silver to produce intense colors with a high degree of saturation as well as low emissivity. If the luminous reflectance of such a coating is higher than desired, it can be reduced, without sacrificing color purity or emissivity, with an optional coating of a neutral metal such as alloys of nickel and iron, particularly Inconel and stainless steel.

The present invention provides the capability of making a series of colored coatings with a minimum of layers and materials. The coating system of the present invention has relatively low reflection, high color saturation and monolithic durability.

It is known that a color series can be made with first and second metal layers surrounding a layer of a

3

transparent dielectric material; the color being varied by changing the thickness of the dielectric layer. However, no previously practiced dielectric has had the required properties of fast sputtering, high refractive index and good durability. The titanium oxynitride of the present invention has the above properties, as well as the ability, in combination with a suitable metal film, to produce intensely colored architectural coatings. For example, titanium oxynitride in combination with a nickel alloy can be used to make a range of attractive colors with excellent durability.

Using reflectance circle diagrams and computer calculations, it is determined that a two layer combination of metal and dielectric has an optimum thickness for both layers which gives the minimum reflectance and highest color saturation combination. The higher the refractive index of the dielectric, the lower the transmission of the coating at the optimum, and the higher the color saturation. Metals with low n and high k, where n and k are the real and complex parts of the complex refractive index, defining the propagation of electromagnetic radiation in the medium, tend to give the lowest transmission and highest saturation.

If the thickness of the metal is increased in an attempt to lower the transmission, the reflectance is increased and a weak color results. Depositing a very thin metal layer prior to the deposition of the dielectric layer can decrease the reflectance and give a more saturated color. If the thickness of the primary metal layer is increased in combination with the deposition of a very thin metal layer, a low transmitting, low reflectance, highly colored coating can be produced. If two primary metal layers are used, a low refractive index dielectric in combination with a low n, high k, metal gives the most attractive appearance. The calculations show that at 20 percent light transmission, adequate saturation can be obtained using a metal in combination with a dielectric with a refractive index of 2.3. For lower light transmission, a metal-dielectric-metal system is preferred.

With the titanium oxynitride of the present invention, many metal or metal alloy films can be used to provide a multiple-layer coating with good properties. Preferred films include metals such as titanium, and metal alloys such as nickel alloys and iron alloys. A nickel alloy is preferred since it is highly chemical resistant, neutral in color and easy to deposit.

A clean glass substrate is placed in a coating chamber which is evacuated, preferably to less than $1.33 \times 10^{-2}$ Pa ($10^{-4}$ torr), more preferably less than $2.66 \times 10^{-3}$ Pa ($2 \times 10^{-5}$ torr). A selected atmosphere of reactive gases, preferably nitrogen and oxygen, is established in the chamber to a pressure between $6.65 \times 10^{-2}$ and 10 Pa ($5 \times 10^{-4}$ and $10^{-2}$ torr). A cathode having a target surface of titanium is operated over the surface of the substrate to be coated. The target metal is sputtered, reacting with the atmosphere in the chamber to deposit a titanium oxynitride coating layer on the glass surface.

After the initial layer of titanium oxynitride is deposited, the coating chamber is evacuated, and an inert atmosphere such as pure argon is established at a pressure between $6.65 \times 10^{-2}$ Pa and 10 Pa ($5 \times 10^{-4}$ and $10^{-2}$ torr). A cathode having a target surface of metal or metal alloy is operated over the titanium oxynitride coated surface. The target is sputtered to deposit a metallic layer on the titanium oxynitride coated glass surface. A preferred metal is titanium. Preferred metal alloys include Inconel, a nickel alloy, and stainless steel, an iron alloy, preferably sputtered at a pressure of 0.533–0.7998 Pa (4 to 6 millitorr) in pure argon.

In some preferred embodiments of the present invention, a metal film is deposited under, as well as over, the titanium oxynitride film. As in the case of a two layer film, the dominant wavelength of the reflected color from the uncoated surface depends almost totally on the thickness of the titanium oxynitride layer. The thickness of the top metal layer is varied until the transmission has about the required value, then the thickness of the underlying metal layer is varied until the desired reflection from the uncoated side of the article is attained. Final modification of the top metal film thickness may be required to obtain the optimum final transmission. Within the thickness range of interest, increasing the thickness of the top metal film decreases the transmission and increases the reflectance from the uncoated side of the coated article. Increasing the thickness of the bottom metal film decreases the transmission and decreases the reflectance from the uncoated side.

In a preferred embodiment of the present invention, a multiple layer film is deposited by cathode sputtering to form a high transmittance, low emissivity coating. In addition to the titanium target, at least one other cathode target surface comprises a metal to be sputtered to form an infrared reflective metallic layer. A multiple layer coating having an infrared reflective metallic layer in combination with an anti-reflective titanium oxynitride layer is produced as follows.

A clean glass substrate is placed in a coating chamber which is evacuated, preferably to less than $10^{-2}$ Pa ($10^{-4}$ torr), more preferably less than $2.66 \times 10^{-3}$ Pa ($2 \times 10^{-5}$ torr). A selected atmosphere of reactive gases, preferably nitrogen and oxygen, is established in the chamber to a pressure between $6.65 \times 10^{-2}$ Pa and $10^{-3}$ Pa ($5 \times 10^{-4}$ and $10^{-5}$ torr). A cathode having a target surface of titanium is operated, preferably at a power level of 5 to 10 kilowatts, over the surface of the substrate to be coated. The target metal is sputtered, reacting with the atmosphere in the chamber to deposit a titanium oxynitride coating layer on the glass surface.

After the initial layer of titanium oxynitride is deposited, the coating chamber is evaluated and an inert atmosphere such as pure argon is established at a pressure between $6.65 \times 10^{-2}$ Pa and 10 Pa ($5 \times 10^{-4}$ and $10^{-2}$ torr). A cathode having a target surface of silver metal is operated over the titanium oxynitride coated surface. The target metal is sputtered and deposits a uniform, highly infrared reflective, conductive metallic layer on the titanium oxynitride coated glass surface. A second layer of titanium oxynitride is deposited on the silver layer under essentially the same conditions used to deposit the first titanium oxynitride layer.

The present invention will be further understood from the descriptions of specific examples which follow.

### EXAMPLE I

A titanium cathode target measuring 12.7 by 43.2 centimeters (5 by 17 inches) is powered at 10 kilowatts in a vacuum chamber containing an atmosphere of 23 percent oxygen and 77 percent nitrogen at a pressure of 0,593 Pa (4 millitorr). The cathode is stationary while a glass substrate passes under the sputtering target surface at a rate of about 3 meters (120 inches) per minute. Four passes deposit a film comprising titanium oxynitride on the glass surface to a luminous transmittance of 75.7 percent.

### EXAMPLE II

A glass substrate is coated with a first layer comprising titanium oxynitride as in Example I. The titanium oxynitride coated surface is then coated with a uniform layer of silver by sputtering a silver cathode target powered at 0.27 kilowatts in an argon atmosphere at a pressure of $5.32\times10^{-1}$ Pa (4 millitorr) to a final luminous transmittance of 68 percent. To protect the silver from oxidation, a very thin protective coating of titanium is deposited in one pass of the titanium cathode powered at 0.03 kilowatts in argon at $5.32\times10^{-1}$ Pa (4 millitorr) to a final luminous transmittance of 67.5 percent.

### EXAMPLE III

A glass substrate is coated with titanium oxynitride and silver as in the previous examples. After depositing the thin, protective layer of titanium, a second layer of titanium oxynitride is deposited to a final luminous transmittance of 82.1 percent, thereby producing a high transmittance, low emissivity coated article.

### EXAMPLE IV

A titanium cathode target measuring about 12.7 by 43.2 centimeters (5 by 17 inches) is powered at 10 kilowatts at 645 volts in a vacuum chamber containing an atmosphere comprising 23 percent oxygen and 77 percent nitrogen at a pressure of $5.32\times10^{-1}$ Pa (4 millitorr). A glass substrate passes the cathode once at a speed of about 2.74 meters (108 inches) per minute and is coated with titanium oxynitride. The chamber is evaluated and an atmosphere of pure argon is introduced at a pressure of $5.32\times10^{-1}$ Pa (4 millitorr). A silver cathode is powered at 441 volts at 2.5 amps to sputter a silver film over the titanium oxynitride coated surface in one pass at about 3.05 meter (120 inches) per minute. To protect the silver film from oxidation, a very thin layer of nickel alloy is deposited over the silver. A target of Inconel 625, which comprises 18.6 percent chromium, 3 percent iron, 4 percent columbium, 9 percent molybdenum and the balance nickel, is powered at 1 amp at 352 volts. The nickel alloy is sputtered in pure argon at 4 millitorr while the substrate passes at about 3.05 meters (120 inches) per minute. The coated article has a luminous transmittance of 21.3 percent and reflectance from the uncoated side of 54.6 percent. The color coordinates from the uncoated surface are x = .3516 and y = .3805. The observed color is pale yellow.

### EXAMPLE V

A titanium oxynitride film in combination with a silver film provides a sufficiently reflective and a sufficiently saturated yellow colored film to simulate the appearance of a gold film. A titanium cathode powered at 10 kilowatts at 640 volts is sputtered as in Example IV except that the atmosphere at $5.32\times10^{-1}$ Pa (4 millitorr) pressure comprises less oxygen. One pass at about 3.05 meters (120 inches) per minute with a slightly oxygen-deficient atmosphere produces a titanium oxynitride film which is somewhat more absorbing than the oxynitride film of Example IV. A silver cathode powered at 441 volts at 2.4 amps is sputtered in pure argon at 0.532 Pa (4 millitorr) to deposit a silver film over the titanium oxynitride coated surface in one pass at about 3.05 meters (120 inches) per minute. To protect the silver film from oxidation, a very thin film of nickel alloy as in Example IV is sputtered in argon at $5.32\times10^{-1}$ Pa (4 millitorr) in one pass at 3.05 m (120 inches) per minute by a cathode target of Inconel 625 metal powered at 356 volts at one amp. The coated article has approximately the same luminous transmittance as the article of Example IV, but the reflectance from the uncoated surface is 40.2 percent and the color coordinates are x = .3833 and y = .4093. The observed color is gold, a more saturated color than that of Example IV. This film survives thermal testing without developing haze.

### EXAMPLE VI

A multiple layer coating of titanium oxynitride and nickel alloy is deposited on a glass substrate under the following conditions. A clean glass substrate is maintained in a vacuum chamber in an atmosphere of 15 percent oxygen and 85 percent nitrogen at a pressure of $7.98 \times 10^{-1}$ Pa (6 millitorr). With a titanium cathode powered at 6.7 kilowatts and a line speed of about 3 meters (120 inches) per minute, eight passes are required to produce a titanium oxynitride coating at a thickness having first order blue color. The titanium oxynitride coated glass surface is then passed under a nickel alloy target in pure argon. The nickel alloy in this example is Inconel 625, which comprises 18.6 percent chromium, 3 percent iron, 4 percent columbium, 9 percent molybdenum and the balance nickel. A layer of nickel alloy is sputtered to a sufficient thickness to reduce the transmittance to 22 percent. The chromaticity coordinates of this coating are x = .3198 and y = .2863 in reflectance from the uncoated glass surface. The observed color is purplish-pink and the luminous reflectance is 5.65 percent from the uncoated glass surface.

EXAMPLE VII

Using the layer system titanium oxynitride-Inconel as in Example VI, a coating with about 20 percent luminous transmittance and an attractive blue color is produced under the conditions given in Table I. Color control of the two layer coating is simple. The thickness of the titanium oxynitride controls the hue. If it is too green, the layer is too thick. If it is too red, the layer is too thin. The thickness of the titanium oxynitride also affects the transmission (or reflectance) since reddish-blue coatings generally have higher transmission than greenish-blue coatings. However, once the hue is fixed, the transmission (or reflectance) can be adjusted by changing the thickness of the Inconel layer. As would be expected, increasing the thickness decreases the transmittance and increases the reflectance. This change has an insignificant effect on the dominant wavelength of the hue. The effects of layer thickness changes, expressed as percentages of the coating thickness produced by conditions in Table I, on the color of five two-layer coatings of this example are presented in Table II.

Table I

| Typical Deposition Conditions for Two Layer Blue Coating at 20 Percent Transmittance | | |
|---|---|---|
| Condition | First Layer | Second Layer |
| Film Composition | Titanium Oxynitride | Nickel Alloy |
| Target Metal | Titanium | Inconel 625 |
| Gas Mixture (volume percent) | 81 nitrogen 19 oxygen | 100 argon |
| Pressure Pa (millitorr) | $5.32 \times 10^{-1}$ (4) | $5.32 \times 10^{-1}$ (4) |
| Power (kilowatts) | 10 | 1.53 |
| Volts | 637 | 424 |
| Target Size cm (inches) | $12.7 \times 43.2$ ($5 \times 17$) | $12.7 \times 43.2$ ($5 \times 17$) |
| Conveyor Speed m/min (inches/minute) | 3 (120) | 3 (120) |
| Final Transmission (percent at 500 nanometers) | 71.6 | 19.4 |

Table II

| | | Reflectance from the Uncoated Surface | | | | |
|---|---|---|---|---|---|---|
| Variation of Color Coordinates with Change in Layer Thickness – 2 Layer Coating | | | | | | |
| Sample | Relative Layer Thickness Oxynitride/Metal | y | x | y | Luminous Transmittance (percent) | Color |
| 2–1001 | 100/100 | 11.5 | .2284 | .2453 | 19.4 | blue |
| 2–1002 | 120/100 | 11.12 | .2280 | .2442 | 18.3 | blue |
| 2–1003 | 83/100 | 17.08 | .2459 | .2834 | 21.3 | greenish-blue |
| 2–1005 | 100/83 | 9.93 | .2266 | .2430 | 23.2 | blue |
| 2–1006 | 100/120 | 14.13 | .2345 | .2559 | 16.1 | blue |

EXAMPLE VIII

A glass substrate is sputter coated as in the previous examples with a first layer of Inconel 625 to luminous transmittance of 60 percent. A titanium oxynitride film is sputtered over the nickel alloy as in the previous examples. A second nickel alloy film is deposited to a final luminous transmittance of 22 percent. The chromaticity coordinates of the coating are x = .2644 and y = .2340 from the glass surface. The observed color is violet and the luminous reflectance is 8.9 percent from the uncoated glass surface.

EXAMPLE IX

A series of three-layer coatings is prepared by varying the thicknesses of the individual titanium oxynitride and Inconel layers. The results for these examples are presented in Table IV, wherein the thicknesses are expressed as percentages of the thicknesses obtained using the conditions stated in Table III.

**Table III**

Typical Deposition Conditions for 3-Layer Blue Coating at 12 Percent Transmittance

| Condition | First Layer | Second Layer | Third Layer |
|---|---|---|---|
| Target Metal | Inconel 625 | Titanium | Inconel 625 |
| Gas Mixture (volume percent) | 100 argon | 82 nitrogen/ 19 oxygen | 100 argon |
| Pressure Pa (millitorr) | $1.33 \times 10^{-1}$ (4) | $1.33 \times 10^{-1}$ (4) | $1.33 \times 10^{-1}$ (4) |
| Power (kilowatts) | 00.4 | 10 | 2.11 |
| Volts | 285 | 637 | 432 |
| Target Size cm (inches) | 12.7 × 43.2 (5 × 17) | 12.7 × 43.2 (5 × 17) | 12.7 × 43.2 (5 × 17) |
| Conveyor Speed cm/min (inches/minutes) | 3 (120) | 3 (120) | 3 (120) |
| Final Transmission (percent at 500 nanometers) | 72.8 | 62.9 | 12.3 |

**Table IV**

Variation of Color Coordinates With Change in Layer Thicknesses – 3 Layer Coating

| Sample | Relative Coating Thickness | | | Reflectance from the Uncoated Surface | | | Color |
|---|---|---|---|---|---|---|---|
| | Bottom Metal | Oxynitride | Top Metal | y | x | y | |
| 2–933 | 100 | 100 | 133 | 17.48 | .2427 | .2527 | blue |
| 2–928 | 100 | 100 | 117 | 15.69 | .2306 | .2661 | greenish/blue |
| 2–923 | 100 | 100 | 100 | 14.44 | .2237 | .2664 | blue |
| 2–929 | 100 | 100 | 83 | 11.43 | .2234 | .2357 | blue |
| 2–934 | 100 | 100 | 67 | 9.00 | .2206 | .2248 | blue |
| 2–926 | 100 | 117 | 100 | 22.16 | .2472 | .2853 | greenish/blue |
| 2–923 | 100 | 100 | 100 | 14.44 | .2237 | .2444 | blue |
| 2–927 | 100 | 83 | 100 | 7.46 | .2710 | .2436 | violet |
| 2–943 | 0 | 100 | 100 | 13.75 | .2367 | .2492 | blue |
| 2–944 | 50 | 100 | 100 | 11.97 | .2386 | .2422 | blue |
| 2–945 | 100 | 100 | 100 | 11.36 | .2252 | .2302 | blue |
| 2–946 | 150 | 100 | 100 | 8.92 | .2143 | .2084 | blue |
| 2–946 | 200 | 100 | 100 | 8.49 | .2048 | .2013 | blue |

EXAMPLE X

A titanium oxynitride film is deposited on a glass surface as in Example VI. A stainless steel film is deposited over the titanium oxynitride. The chromaticity coordinates of this coating are x = .2466 and y = .2680 from the glass surface. The observed color is greenish-blue and the luminous reflectance is 18.5 percent from the uncoated glass surface.

EXAMPLE XI

A titanium oxynitride film is deposited in 8 passes on a glass surface as in the previous examples. A titanium metal film is deposited by sputtering a titanium cathode in argon. The chromaticity coordinates of the coating are x = .3317 and y = .3037 from the glass surface. The observed color is purplish-pink and the luminous reflectance is 5.17 percent from the uncoated glass surface.

EXAMPLE XII

A titanium oxynitride film is deposited in 9 passes on a glass surface as in Example XI. A titanium metal film is deposited by sputtering a titanium cathode in argon. The chromaticity coordinates of the coating are x = .2402 and y = .2265 from the glass surface. The observed color is purplish-blue and the luminous reflectance is 5.32 percent from the uncoated glass surface.

The above examples are offered to illustrate the advantages of the present invention. The coatings in Tables II and III are not attacked in 24 hours by cold 20 percent hydrochloride acid or cold 30 percent nitric acid. In the five hour 135°C (275°F) heat test, there is a small transmittance and a small reflected color change. This would be consistent with a growth of protective oxide on the Inconel surface, a process which should be self-limiting.

In the Cleveland condensing humidity test at about 66°C (150°F), no change was observed in the coatings in four months. The coatings are not affected by abrading with a pencil eraser, nor by the cycling bristle brush test, used to evaluate the coatings for internal monolithic glazing. However, rubbing with wet or dry pumice shows that the coating is not as hard as coatings comprising titanium nitride.

The titanium oxynitride/metal alloy combination of layers can produce a few attractive products. However, the metal/titanium oxynitride/metal system can produce a much broader range of reflectance colors and transmissions using only two materials. Titanium oxynitride is transparent, chemically resistant, has a high-index of refraction and is as fast to deposit as the oxides of tin and zinc, which have inferior properties. The concentration of oxygen in nitrogen is not as critical to the process as might be thought unless the deposition rate is pushed to its absolute maximum. This relieves the complication that in-machine monitors are only reliable in the transmission mode which cannot distinguish a decrease in transmission from an increase in film thickness from a decrease in transmission due to an increase in absorption. Thus, color control for the two-layer coating should not be difficult. Color control is slightly more complicated for the three layer coating, which, for instance, if too reflective, can be made less so either by making the top metal layer thinner or the bottom metal layer thicker.

The above examples are offered to illustrate the present invention. Various sputtering conditions may be employed, the ratio of oxygen and nitrogen may be varied and the titanium oxynitride film of the present invention may be employed at various thicknesses and configurations with other metal-containing films to provide a wide array of reflective colors. The scope of the present invention is defined by the following claims.

## Claims

1. A method of making a coated article by placing a substrate in a coating chamber, evacuating said chamber and providing a nitrogen comprising reactive atmosphere and depositing a coating onto the surface of said substrate by sputtering a titanium cathode facing the surface of said substrate characterized by providing an atmosphere further comprising oxygen in said chamber and depositing a transparent titanium oxynitride coating on said surface of a transparent non-metallic substrate.

2. The method of claim 1, wherein said substrate is glass, ceramics or plastic, which is not detrimentally affected by the operating conditions.

3. The method according to claim 1, wherein said atmosphere comprises from 10 to 50 percent oxygen and 50 to 90 percent nitrogen.

4. The method according to claim 1, wherein a second layer, of a highly infrared reflective metal film is deposited on a surface of said substrate.

5. The method according to claims 1 and 4, wherein as a further step a third layer is deposited on said substrate comprising titanium oxynitride.

6. The method according to claims 1, 4 and 5, wherein a first layer of titanium oxynitride is deposited on said substrate, a layer of a highly infrared reflective metal film is deposited over the titanium oxynitride, and a second titanium oxynitride layer is deposited over the highly infrared reflective metal film.

7. The method according to claim 4 wherein as a further step a third layer is deposited on said substrate comprising a second metallic film.

8. The method according to claim 7, wherein said second metallic film comprises a metal alloy selected from the group of nickel alloys and iron alloys, stainless steel and Inconel.:

9. The method according to claims 4 and 6, wherein said highly infrared reflective metal film is selected from the group consisting of copper, silver or gold.

10. The method according to claim 1, wherein a second layer of a metallic film is deposited in an inert atmosphere on a surface of said substrate.

11. The method according to claims 1 and 10, wherein a third layer of a metallic film is deposited on said substrate.

12. The method according to claims 1, 10 and 11, wherein said titanium oxynitride film is deposited between said first and second metallic films.

13. The method according to claims 10, 11 and 12, wherein said metal is selected from the group consisting of nickel alloys, iron alloys, titanium and mixtures thereof.

14. The method according to claim 13, wherein said metal alloy is selected from the group consisting of stainless steel and Inconel.

15. The method according to claims 4 to 14, wherein the further layers are deposited by sputtering.

16. Use of the coated article prepared according to the claims 1 to 6, 9 and 15 as a structural element for the reflectance of solar energy.

17. Use of the coated article prepared according to the claims 1 to 9 and 15 having a reduced total luminous reflectance as a structural element for the reflectance of solar energy.

18. Use of the coated article prepared according to the claims 1 to 3 and 10 to 15 as a colored architectural product.


**Patentansprüche**

1. Verfahren zum Herstellen eines beschichteten Gegenstandes durch Anordnen eines Trägermaterials in einer Beschichtungskammer, Evakuieren der Kammer und Schaffen einer Stickstoff enthaltenden reaktiven Atmosphäre und Ablagern einer Beschichtung auf der Oberfläche des Trägermaterials durch Zerstäuben einer der Oberfläche des Trägermaterials zugewandten Titankathode, gekennzeichnet durch Schaffen einer Atmosphäre in der Kammer, die noch Sauerstoff enthält und Ablagern einer transparenten Titanoxinitridbeschichtung auf der Oberfläche eines transparenten nichtmetallischen Trägermaterials.

2. Verfahren nach Anspruch 1, dadurch gekennzeichnet, daß das Trägermaterial Glas, Keramik oder Kunststoff ist, der durch die Arbeitsbedingungen nicht negativ beeinflußt wird.

3. Verfahren nach Anspruch 1, dadurch gekennzeichnet, daß die Atmosphäre von 10–50% Sauerstoff und von 50–90% Stickstoff enthält.

4. Verfahren nach Anspruch 1, dadurch gekennzeichnet, daß eine zweite Schicht eines stark Infrarotstrahlung reflektierenden Metallfilmes auf einer Oberfläche des Trägermaterials abgelagert wird.

5. Verfahren nach Ansprüchen 1 und 4, dadurch gekennzeichnet, daß als ein weiterer Schritt eine dritte Schicht auf dem Trägermaterial abgelagert wird, die Titanoxinitrid enthält.

6. Verfahren nach Ansprüchen 1, 4 und 5, dadurch gekennzeichnet, daß eine erste Schicht aus Titanoxinitrid auf dem Trägermaterial abgelagert wird, eine Schicht von stark Infrarotstrahlung reflektierendem Metallfilm auf der Titanoxinitridschicht abgelagert wird und eine zweite Titanoxinitridschicht auf dem stark Infrarotstrahlung reflektierenden Metallfilm abgelagert wird.

7. Verfahren nach Anspruch 4, dadurch gekennzeichnet, daß als ein weiterer Schritt eine dritte Schicht auf dem Trägermaterial abgelagert wird, die einen zweiten Metallfilm enthält.

8. Verfahren nach Anspruch 7, dadurch gekennzeichnet, daß der zweite Metallfilm eine Metallegierung enthält ausgewählt aus der Gruppe von Nickellegierungen, Eisenlegierungen, rostfreiem Stahl und Inconel.

9. Verfahren nach Ansprüchen 4 und 6, dadurch gekennzeichnet, daß der stark Infrarotstrahlung reflektierende Metallfilm ausgewählt ist aus der Gruppe bestehend aus Kupfer, Silber oder Gold.

10. Verfahren nach Anspruch 1, dadurch gekennzeichnet, daß eine zweite Schicht des Metallfilms in einer inerten Atmosphäre auf der Oberfläche des Trägermaterials abgelagert wird.

11. Verfahren nach Ansprüchen 1 und 10, dadurch gekennzeichnet, daß eine dritte Schicht eines Metallfilms auf dem Substrat abgelagert wird.

12. Verfahren nach Ansprüchen 1, 10 und 11, dadurch gekennzeichnet, daß der Titanoxinitridfilm abgelagert wird zwischen dem ersten und dem zweiten Metallfilm.

13. Verfahren nach Ansprüchen 10, 11 und 12, dadurch gekennzeichnet, daß das Metall ausgewählt ist aus der Gruppe bestehend aus Nickellegierungen, Eisenlegierungen, Titan und Mischungen derselben.

14. Verfahren nach Anspruch 13, dadurch gekennzeichnet, daß die Metallegierung ausgewählt ist aus der Gruppe bestehend aus rostfreiem Stahl und Inconel.

15. Verfahren nach Ansprüchen 4–14, dadurch gekennzeichnet, daß die weiteren Schichten durch Kathodenzerstäubung abgelagert werden.

16. Verwendung des beschichteten Gegenstandes hergestellt nach den Ansprüchen 1–6, 9 und 15 als Bauteil für das Reflektieren von Sonnenenergie.

17. Verwendung des beschichteten Gegenstandes hergestellt nach den Ansprüchen 1–9 und 15 mit verringerter Gesamtlichtreflexion als Bauteil für das Reflektieren von Sonnenenergie.

18. Verwendung des beschichteten Gegenstandes hergestellt nach den Ansprüchen 1–3 und 10–15 als ein gefärbtes Bauprodukt.

**Revendications**

1. Procédé de fabrication d'un article revêtu en introduisant un subjectile ou support dans une chambre de revêtement, en faisant le vide dans la chambre en question et en réalisant une atmosphère réactive azotée et déposant un revêtement à la surface du subjectile ou support précité par projection d'une cathode de titane qui fait face à la surface du support ou subjectile concerné, caractérisé en ce qui on réalise dans la chambre une atmosphère comprenant également de l'oxygène et on dépose un revêtement d'oxynitrure de titane transparent sur la surface d'un support subjectile non métallique transparent.

2. Procédé suivant la revendication 1, caractérisé en ce que le support ou subjectile précité est constitué de verre, d'une matière céramique ou d'une matière plastique, qui n'est pas affectée de manière préjudiciable par les conditions opératoires.

3. Procédé suivant la revendication 1, caractérisé en ce que l'atmosphère précitée comprend de 10 à 50% d'oxygène et de 50 à 90% d'azote.

4. Procédé suivant la revendication 1, caractérisé en ce que l'on dépose une seconde couche d'une pellicule de métal réfléchissant fortement l'infrarouge à la surface du support subjectile précité.

5. Procédé suivant les revendications 1 et 4, caractérisé en ce qu'à titre d'étape supplémentaire, on dépose une troisième couche constituée d'oxynitrure de titane sur le support ou subjectile précité.

6. Procédé suivant les revendications 1, 4 et 5, caractérisé en ce que l'on dépose une première couche d'oxynitrure de titane sur le subjectile ou support précité, on dépose une couche d'une pellicule de métal réfléchissant fortement l'infrarouge sur l'oxynitrure de titane et on dépose une seconde couche d'oxynitrure de titane sur la pellicule de métal réfléchissant fortement l'infrarouge.

7. Procédé suivant la revendication 4, caractérisé en ce qu'à titre d'étape supplémentaire, on dépose une troisième couche constituée d'une seconde pellicule de métal sur le support ou subjectile précité.

8. Procédé suivant la revendication 7, caractérisé en ce que la seconde pellicule de métal précitée est constituée d'un alliage de métaux choisis dans le groupe formé par les alliages du nickel et les alliages du fer, l'acier inoxydable et l'Inconel.

9. Procédé suivant les revendications 4 et 6, caractérisé en ce que l'on choisit la pellicule de métal réfléchissant fortement l'infrarouge dans le groupe formé par le cuivre, l'argent et l'or.

10. Procédé suivant la revendication 1, caractérisé en ce que l'on dépose une seconde couche d'une pellicule de métal en atmosphère inerte à la surface du support ou subjectile précité.

11. Procédé suivant les revendications 1 et 10, caractérisé en ce que l'on dépose une troisième couche d'une pellicule de métal sur le support ou subjectile précité.

12. Procédé suivant les revendications 1, 10 et 11, caractérisé en ce que l'on dépose la pellicule d'oxynitrure de titane entre lesdites première et seconde pellicules de métal.

13. Procédé suivant les revendications 10, 11 et 12, caractérisé en ce que l'on choisit le métal précité dans le groupe formé par les alliages du nickel, les alliages du fer, le titane et leurs mélanges.

14. Procédé suivant la revendication 13, caractérisé en ce que l'on choisit l'alliage de métal dans le groupe formé par l'acier inoxydable et l'Inconel.

15. Procédé suivant les revendications 4 à 14, caractérisé en ce que l'on dépose les couches supplémentaires par projection.

16. Utilisation de l'article revêtu préparé par mise en œuvre du procédé suivant l'une quelconque des revendications 1 à 6, 9 et 15 à titre d'élément structural pour la réflexion de l'énergie solaire.

17. Utilisation de l'article revêtu fabriqué par mise en œuvre du procédé suivant l'une quelconque des revendications 1 à 9 et 15, possédant une réflexion lumineuse totale réduite, à titre d'élément structural pour la réflexion de l'énergie solaire.

18. Utilisation de l'article revêtu fabriqué par mise en œuvre des revendications 1 à 3 et 10 à 15, à titre de produit architectural coloré.

FIG.1   TRANSMISSION AT 550 nm

20%O₂

19%O₂

18%O₂

17%O₂

16%O₂

TRANSMISSION (%)

THICKNESS (Number of Passes)

FIG.2 DEPOSITION RATE VERSUS OXYGEN CONCENTRATION

# FIG.3  ABSORPTION VERSUS OXYGEN CONCENTRATION

## FIG.4 TRANSMISSION VERSUS THICKNESS

7 kW

8 kW

9 kW

10 kW

TRANSMISSION (%)

THICKNESS (Number of Passes)

EP 0 283 923 B1